# EUROPÄISCHE PATENTSCHRIFT

(11) **EP 3 537 168 B1**
(45) Veröffentlichungstag und Bekanntmachung des Hinweises auf die Patenterteilung: **05.01.2022**
(21) Anmeldenummer: 18160710.2
(22) Anmeldetag: 08.03.2018
(51) Int. Cl.: G01R 33/50, G01R 33/483, G01R 33/56

(54) **VERFAHREN ZUR AUFNAHME VON MAGNETRESONANZDATEN FÜR DIE QUANTITATIVE MAGNETRESONANZBILDGEBUNG, MAGNETRESONANZEINRICHTUNG, COMPUTERPROGRAMM UND ELEKTRONISCH LESBARER DATENTRÄGER**
METHOD FOR RECORDING MAGNETIC RESONANCE DATA FOR QUANTITATIVE MAGNETIC RESONANCE IMAGING, MAGNETIC RESONANCE DEVICE, COMPUTER PROGRAM AND ELECTRONICALLY READABLE DATA CARRIER
PROCÉDÉ D'ENREGISTREMENT DE DONNÉES DE RÉSONANCE MAGNÉTIQUE POUR L'IMAGERIE PAR RÉSONANCE MAGNÉTIQUE QUANTITATIVE, DISPOSITIF DE RÉSONANCE MAGNÉTIQUE, PROGRAMME INFORMATIQUE ET SUPPORT D'INFORMATIONS LISIBLE PAR VOIE ÉLECTRONIQUE

(43) Veröffentlichungstag der Anmeldung: 11.09.2019
(73) Patentinhaber: Siemens Healthcare GmbH, 91052 Erlangen (DE)
(72) Erfinder: Paul, Dominik, 91088 Bubenreuth (DE); Carinci, Flavio, 91052 Erlangen (DE); Zeller, Mario, 91054 Erlangen (DE)

(56) Entgegenhaltungen:
- WU H. ET AL.: "Fast T1 Mapping Using Slice-Shuffled Simultaneous Multi-Slice Inversion Recovery EPI", PROCEEDINGS OF THE INTERNATIONAL SOCIETY FOR MAGNETIC RESONANCE IN MEDICINE, 23RD ANNUAL MEETING & EXHIBITION, Nr. 440, 15. Mai 2015 (2015-05-15), Seite 0440, XP040666123, Toronto, Canada
- KALPATHY-CRAMER J. ET AL.: "Simultaneous UHF quantitative T1 mapping and T2* weighted dynamic contrast imaging with applications to brain tumors", PROCEEDINGS OF THE INTERNATIONAL SOCIETY FOR MAGNETIC RESONANCE IN MEDICINE, 23RD ANNUAL MEETING & EXHIBITION, Nr. 4392, 15. Mai 2015 (2015-05-15), Seite 4392, XP040670068, Toronto, Canada
- RENVALL V. ET AL.: "Fast variable inversion-recovery time EPI for anatomical reference and quantitative T1 mapping", PROCEEDINGS OF THE INTERNATIONAL SOCIETY FOR MAGNETIC RESONANCE IN MEDICINE, JOINT ANNUAL MEETING ISMRM-ESMRMB, Nr. 4282, 28. April 2014 (2014-04-28), Seite 4282, XP040671055, Milan, Italy
- GRINSTEAD J.W. ET AL.: "Slice-Accelerated Inversion Recovery T1 Mapping", PROCEEDINGS OF THE INTERNATIONAL SOCIETY FOR MAGNETIC RESONANCE IN MEDICINE, JOINT ANNUAL MEETING ISMRM-ESMRMB, Nr. 3215, 28. April 2014 (2014-04-28), Seite 3215, XP040664284, Milan, Italy
- YUN JIANG ET AL: "Use of pattern recognition for unaliasing simultaneously acquired slices in simultaneous multislice MR fingerprinting : Simultaneous Multislice MR Fingerprinting", MAGNETIC RESONANCE IN MEDICINE., Bd. 78, Nr. 5, 26. Dezember 2016 (2016-12-26), Seiten 1870-1876, XP055503004, US ISSN: 0740-3194, DOI: 10.1002/mrm.26572

## Beschreibung

Die Erfindung betrifft ein Verfahren zur Aufnahme von Magnetresonanzdaten zur Ermittlung wenigstens einer einen Materialparameter in dem Aufnahmebereich beschreibenden Parameterkarte mit einer Magnetresonanzeinrichtung, wobei das Aufnahmegebiet mehrere Schichten aufweist und zur Aufnahme der Magnetresonanzdaten wenigstens teilweise ein schichtspezifischer Präparationspuls verwendet wird, wobei Magnetresonanzdaten nach unterschiedlichen Wartezeiten nach dem Präpararationspuls vermessen werden. Daneben betrifft die Erfindung eine Magnetresonanzeinrichtung, ein Computerprogramm und einen elektronisch lesbaren Datenträger.

Die Magnetresonanzbildgebung ist im klinischen Einsatz inzwischen etabliert. Neben der klassischen Aufnahme von Magnetresonanzbildern gewinnt dabei zunehmend die quantitative Magnetresonanzbildgebung an Bedeutung. Bei der quantitativen Magnetresonanzbildgebung werden mit unterschiedlichen Aufnahmeparametern Magnetresonanzdaten aus denselben Schichten des Aufnahmebereichs aufgenommen, um hieraus rechnerisch Materialparameter abzuleiten, die dann in Form einer Parameterkarte dargestellt werden können. Die Materialparameter können dabei beispielsweise die T1-Relaxationszeit, die T2-Relaxationszeit, die T2*-Relaxationszeit, die Protonendichte sowie die magnetische Suszeptibilität umfassen. Die Genauigkeit solcher Parameterkarten hängt letztlich von der Anzahl an Messpunkten ab, das bedeutet, auf wieviel unterschiedliche Arten Magnetresonanzdaten von bestimmten Punkten im Raum aufgenommen wurden, wobei hier meist unterschiedliche Kontrastparameter als Aufnahmeparameter eingesetzt werden.

Im Hinblick auf einen klinischen Einsatz ergeben sich durch die mehrfache Aufnahme von Magnetresonanzdaten aus den einzelnen Schichten, insbesondere dann, wenn für eine Vielzahl von Materialparametern Parameterkarten ermittelt werden sollen, sehr lange Messzeiten, welche mit den kurz angesetzten Untersuchungszeiten heutiger Zeit nicht vereinbar sind.

Um unterschiedliche Magnetresonanzdaten aus den Schichten zu erhalten, aus denen sich Materialparameter bestimmen lassen, wurde vorgeschlagen, Magnetresonanzdaten bei unterschiedlichen Wartezeiten nach der Ausgabe eines Präparationspulses aufzunehmen, wobei insbesondere als Präparationspuls ein Inversionspuls verwendet wird und mithin verschiedene Inversionszeiten TI betrachtet werden. Hieraus lässt sich als Materialparameter insbesondere die T1-Relaxationszeit ermitteln. Nach Inversions-Präparationen sind jedoch lange Repetitionszeiten TR nötig, um möglichst viel Magnetresonanzsignal zu relaxieren, was wiederum zu sehr hohen Aufnahmezeiten führt. Basiert beispielsweise die Aufnahme der Magnetresonanzdaten auf einer Spinechosequenz, beispielsweise einer Turbospinechosequenz (TSE-Sequenz), kann nicht unmittelbar nach einer ersten Datenaufnahme zu einer ersten Inversionszeit eine Aufnahme der gleichen Schicht für eine zweite Inversionszeit erfolgen, da kein Magnetresonanzsignal mehr vorhanden ist. Daher werden die zwei Aufnahmen der Magnetresonanzdaten separat durchgeführt. Oftmals sind in diesem Zusammenhang auch mehrere Concatenations notwendig. Es resultiert eine lange Aufnahmezeit.

DE 10 2012 206 585 A1 betrifft ein Verfahren zur schnellen ortsaufgelösten Bestimmung eines Magnetresonanz-Relaxationsparameters in einem Untersuchungsgebiet. Dort wird vorgeschlagen, nach einem Präparationspuls für eine Schicht während der Relaxation der longitudinalen Magnetisierung zu mindestens zwei verschiedenen Inversionszeiten mittels einer schnellen Magnetresonanzsequenz ortskodierte Magnetresonanzsignale zu akquirieren, um zu jeder Inversionszeit einen Bilddatensatz zu rekonstruieren. Die rekonstruierten Bilddatensätze werden zueinander elastisch registriert und aus den registrierten Bilddatensätzen wird ortsrichtig der Relaxationsparameter bestimmt.

Zur Messzeitreduktion bei der quantitativen Magnetresonanzbildgebung mit einer Datenaufnahme nach Präparationspulsen wurde auch bereits vorgeschlagen, Bildgebungstechniken wie die parallele Bildgebung (PAT-Parallel Acquisition Technique) und Compressed Sensing (CS) einzusetzen. Jedoch ist die gesamte Aufnahmezeit noch immer recht hoch, so dass eine weitere Beschleunigung wünschenswert ist.

Ein Artikel von Hua Wu et al., "Fast T1 Mapping Using Slice-Shuffled Simultaneous Multi-Slice Inversion Recovery EPI", Proc. Intl. Soc. Mag. Reson. Med. 23 (2014), Seite 440, beschreibt eine Möglichkeit zur Kartierung von T1-Relaxationszeiten unter Verwendung von SMS, wobei ein nicht selektiver, adiabatischer Inversionspuls verwendet wird und Schichten sequentiell ausgelesen werden. Ähnliche Vorgehensweisen werden durch folgende Artikel beschrieben:
- Jayashree Kalpathy-Cramer et al., "Simultaneous UHF quantitative T1 mapping and T2* weighted dynamic contrast imaging with application to brain tumors", Proc. Intl. Soc. Mag. Reson. Med. 23 (2015), S. 4392.
- Ville Renvall et al., "Fast variable inversion-recovery time EPI for anatomical reference and quantitative T1 mapping", Proc. Intl. Soc. Mag. Reson. Med. 22 (2014), Seite 4282.
- John W. Grinstead et al., "Slice-Accelerated Inversion Recovery T1 Mapping", Proc. Intl. Soc. Mag. Reson. Med. 22 (2014), Seite 3215.

Ein Artikel von Yun Jiang et al., "Use of Pattern Recognition for Unaliasing Simultaneously Acquired Slices in Simultaneous Multislice MR Fingerprinting", Mag. Reson. Med. 78 (2017), Seiten 1870-1876, schlägt das Design eines Mehrband-Hochfrequenzpulses derart vor, dass zwei Schichten mit unterschiedlichen Flipwinkeln und unterschiedlichen Phasen angeregt werden.

Der Erfindung liegt daher die Aufgabe zugrunde, eine Möglichkeit zur Beschleunigung der Messung bei der quantitativen Magnetresonanzbildgebung mit schichtselektiven Präparationen anzugeben.

Zur Lösung dieser Aufgabe ist bei einem Verfahren der eingangs genannten Art erfindungsgemäß vorgesehen, dass zur Aufnahme von Magnetresonanzdaten unterschiedlicher Wartezeiten aus wenigstens zwei Schichten ein durch Überlagerung der schichtspezifischen Präparationspulse für die einzelnen Schichten ermittelter Gesamtpuls ausgegeben wird und die Magnetresonanzdaten der Schichten nach den jeweiligen Wartezeiten mit einer Auslesesequenz ausgelesen werden, wobei schichtspezifische Präparationspulse unterschiedlicher Flipwinkel zu dem Gesamtpuls überlagert werden.

Erfindungsgemäß wird also eine Verschachtelung der Aufnahme von Magnetresonanzdaten aus unterschiedlichen Schichten bei gleichzeitiger Anwendung von Präparationspulsen gemäß der Mehrschichtbildgebung (SMS - Simultaneous Multi Slice) vorgeschlagen. Es wird mithin ein Gesamtpuls verwendet, der vergleichbar zur SMS-Bildgebung durch Überlagerung von schichtspezifischen Präparationspulsen ermittelt wurde und mithin auf zwei oder mehr Schichten gleichzeitig wirkt. Das bedeutet, im Gegensatz zu dem bekannten Vorgehen werden zwei oder mehr Schichten gleichzeitig akquiriert. Die Magnetresonanzdaten der wenigstens zwei präparierten Schichten können zu zwei verschiedenen Zeitpunkten, also zu unterschiedlichen Wartezeiten, ausgelesen werden. Damit lassen sich die Aufnahmevorgänge ineinander verschachteln und es kann mithin ein deutlicher Zeitgewinn, insbesondere um den Faktor 2 oder mehr, erzielt werden.

Im Rahmen der vorliegenden Erfindung wurde also erkannt, dass es zwar nicht sinnvoll möglich sein mag, nach einem einzigen Präparationspuls innerhalb derselben Schicht, beispielsweise bei Verwendung einer TSE-Sequenz, zu zwei verschiedenen Wartezeiten, insbesondere Inversionszeiten, Magnetresonanzdaten aufzunehmen, die damit zusammenhängenden Probleme jedoch umgangen werden, wenn zwei unterschiedliche Schichten gewählt werden, die beide präpariert werden, indem gemäß der SMS-Bildgebung ihre schichtspezifischen Präparationspulse zu einem gemeinsamen Gesamtpuls zusammengeführt und ausgegeben werden, wobei die Auslese-Echozüge gemäß der Auslesesequenz zeitlich gegeneinander so versetzt sind, dass für eine Schicht die erste Wartezeit, für die andere Schicht die zweite Wartezeit abgedeckt wird.

Es ist in diesem Zusammenhang besonders zweckmäßig, wenn in einer weiteren Repetition die Schichten vertauscht werden, das bedeutet, die zweite Schicht dann nach der ersten Wartezeit und die erste Schicht nach der zweiten Wartezeit ausgelesen werden, so dass schließlich Magnetresonanzdaten zu allen Wartezeiten aus allen Schichten vorliegen. Dies lässt sich selbstverständlich entsprechend auf die gleichzeitige Präparation von mehr als zwei Schichten übertragen.

Zweckmäßigerweise kann als Auslesesequenz eine Spinechosequenz, insbesondere eine Turbo-Spinechosequenz (TSE-Sequenz), und/oder als schichtspezifischer Präparationspuls wenigstens ein Inversionspuls und/oder ein Sättigungspuls verwendet werden. Das bedeutet, das Verfahren kann insbesondere auch mit verschiedenen denkbaren schichtselektiven Präparationen eingesetzt werden.

Erfindungsgemäß ist vorgesehen, dass schichtspezifische Präparationspulse unterschiedlicher Flipwinkel zu dem Gesamtpuls überlagert werden. Das bedeutet, der Flipwinkel des schichtspezifischen Präparationspulses kann für die wenigstens zwei gleichzeitig zu präparierenden Schichten unterschiedlich eingestellt werden. Dies eröffnet zum einen die Möglichkeit, unterschiedliche Kontraste aufzunehmen, beispielsweise einen IR-Kontrast (Inversion Recovery-Kontrast) und einen SR-Kontrast (Saturation Recovery-Kontrast). Damit wird ein zusätzlicher Freiheitsgrad genutzt, der die Qualität und Genauigkeit der Parameterkarten weiter erhöht. Zudem bietet die Möglichkeit zur Variation der Flipwinkel eine Option zur Reduzierung der spezifischen Absorptionsrate (SAR) für den Patienten, so dass auch diesbezüglich Vorteile gewonnen werden können.

In Weiterbildung der Erfindung kann ferner vorgesehen sein, dass wenigstens drei Schichten vermessen werden, wobei für wenigstens zwei Schichten, auf die der Gesamtpuls wirkt, die Magnetresonanzdaten einer gemeinsamen Wartezeit gleichzeitig ausgelesen und mittels eines Trennungsalgorithmus getrennt werden. Das bedeutet, die hier beschriebene gleichzeitige Präparation mehrerer Schichten zur Auslesung zu unterschiedlichen Wartezeiten kann kombiniert werden mit konventionellen SMS-Bildgebungstechniken, so dass beispielsweise durch den Gesamtpuls vier Schichten gleichzeitig präpariert werden und jeweils zwei Mal zwei Schichten gleichzeitig ausgelesen werden können. Auf diese Weise kann eine weitere Beschleunigung der Aufnahme der Magnetresonanzdaten erreicht werden.

Neben dem Verfahren betrifft die vorliegende Erfindung auch eine Magnetresonanzeinrichtung, aufweisend eine zur Durchführung des erfindungsgemäßen Verfahrens ausgebildete Steuereinrichtung. Die Steuereinrichtung weist dabei zweckmäßigerweise wenigstens einen Prozessor und wenigstens ein Speichermittel auf. Sämtliche Ausführungen bezüglich des erfindungsgemäßen Verfahrens lassen sich analog auf die erfindungsgemäße Magnetresonanzeinrichtung übertragen, so dass auch mit dieser die genannten Vorteile erhalten werden können. Zweckmäßigerweise kann eine derartige Steuereinrichtung neben einer grundsätzlich bekannten Sequenzeinheit, die die Aufnahme von Magnetresonanzdaten steuert, eine Gesamtpulsermittlungseinheit bzw. Planungseinheit zur Ermittlung des Gesamtpulses durch Überlagerung der schichtspezifischen Präparationspulse und/oder zur Planung des Zeitablaufes aufweisen.

Ein erfindungsgemäßes Computerprogramm ist beispielsweise direkt in einen Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzeinrichtung ein erfindungsgemäßes Verfahren durchführen. Bei dem Datenträger kann es sich um ein nichttransienten Datenträger, insbesondere eine CD-ROM handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: den Zeitablauf der Datenaufnahme aus gemeinsam präparierten Schichten in einem ersten Ausführungsbeispiel,
- Fig. 2: den Zeitablauf bei der Datenaufnahme aus gemeinsam präparierten Schichten in einem zweiten Ausführungsbeispiel, und
- Fig. 3: eine erfindungsgemäße Magnetresonanzeinrichtung.

In den folgenden Ausführungsbeispielen soll quantitative Magnetresonanzbildgebung, insbesondere wenigstens bezüglich der T1-Relaxationszeit als Materialparameter, in einem Aufnahmebereich eines Patienten angewendet werden, der in mehrere Schichten unterteilt ist. Als Präparationspuls soll ein Inversionspuls eingesetzt werden, wobei nach unterschiedlichen Wartezeiten, also Inversionszeiten, Magnetresonanzdaten aus den entsprechenden Schichten aufgenommen werden sollen.

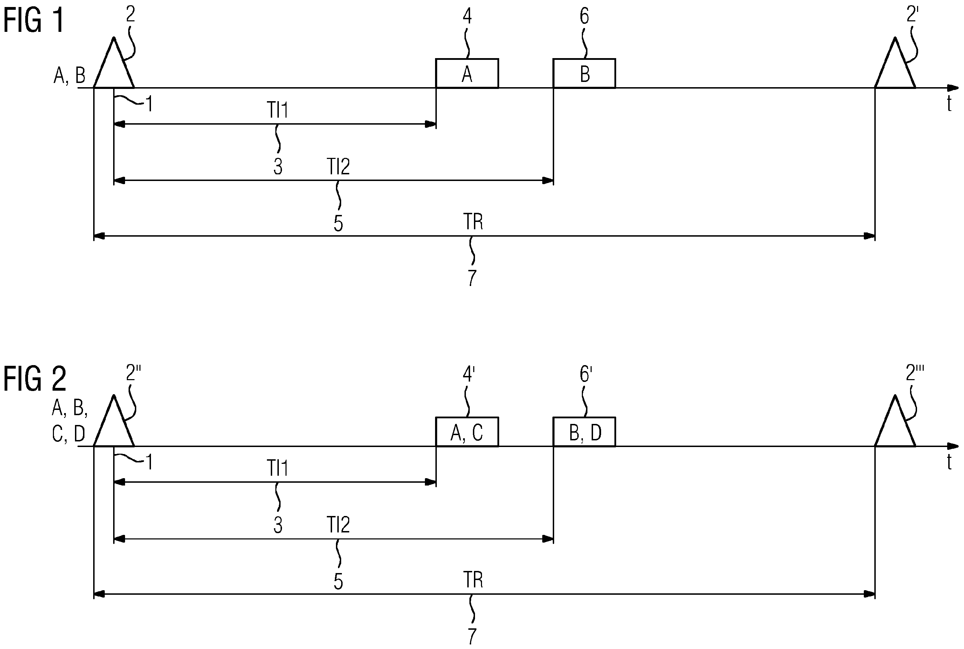

In einem ersten konkreten Ausführungsbeispiel, das im Hinblick auf Fig. 1 genauer erläutert werden soll, sollen bei der Vermessung von zwei unterschiedlichen Wartezeiten TI1 und TI2 alle Schichten in Paare von je zwei Schichten A, B aufgeteilt werden. Die Aufteilung erfolgt dabei wie in der SMS-Bildgebung so, dass möglichst wenig Schicht-Crosstalk bei einer Beeinflussung der Schichten innerhalb einer gemeinsamen Repetition auftritt.

Zur Aufnahme der Magnetresonanzdaten wird nun zunächst ein Gesamtpuls nach Methoden der SMS-Bildgebung aus zwei schichtspezifischen Präparationspulsen durch Überlagerung ermittelt.

Während des tatsächlichen Aufnahmevorgangs wird mithin zu einem Zeitpunkt 1 durch Ausgabe des hier nur angedeuteten Gesamtpulses 2 eine Präparation beider Schichten A, B erzielt. Nach einer ersten Wartezeit 3 kann dann in einem Auslese-Echozug 4, der als Auslesesequenz vorliegend eine TSE-Sequenz nutzt, eine Aufnahme von Magnetresonanzdaten aus der ersten Schicht erfolgen. Nach einer zweiten Wartezeit 5 erfolgt in einem weiteren Auslese-Echozug 6, wiederum unter Nutzung einer TSE-Sequenz, die Aufnahme von Magnetresonanzdaten aus der zweiten Schicht B.

Nach der Repetitionszeit TR wird der nächste Gesamtpuls 2' für das nächste Paar von Schichten A', B' ausgegeben. Zu einem späteren Zeitpunkt, in einer weiteren Repetition, erfolgt im Übrigen eine umgekehrte Vermessung der Schichten A, B (sowie der weiteren Paare), das bedeutet, es werden Magnetresonanzdaten der Schicht B nach der ersten Wartezeit 3 und Magnetresonanzdaten der Schicht A nach der zweiten Wartezeit 5 aufgenommen. Die Repetitionszeit ist in Fig. 1 zusätzlich mit dem Bezugszeichen 7 gekennzeichnet.

Nachdem für alle Paare und alle Wartezeiten 3, 5 (sowie gegebenenfalls weitere Paare von Wartezeiten) Magnetresonanzdaten aufgenommen wurden, können diese entsprechend weiterverarbeitet werden, insbesondere durch Rekonstruktion von Magnetresonanzbildern zu den entsprechenden Kontrasten und Verarbeitung derselben, um Parameterkarten, insbesondere wenigstens bezüglich der T1-Relaxationszeit, zu ermitteln.

Dabei sei noch darauf hingewiesen, dass erfindungsgemäss Flipwinkel für die zu überlagernden Präparationspulse verwendet werden, da hierdurch nicht nur SAR eingespart werden kann, sondern auch weiter unterschiedliche Kontraste vermessen werden können.

Fig. 2 zeigt eine Kombination des Vorgehens der Fig. 1 mit der konventionellen Magnetresonanzbildgebung. Der dort gezeigte Gesamtpuls 2ʺ wirkt hier nicht nur auf Schichten A und B, sondern auch auf Schichten C und D. Dabei sollen aus der Schicht C ebenso nach der ersten Wartezeit 3 Magnetresonanzdaten vermessen werden, aus der Schicht D ebenso nach der zweiten Wartezeit 5. Entsprechend werden in den Auslese-Echozügen 4', 6' jeweils überlagerte Magnetresonanzdaten der Schichten A, C bzw. B, D aufgenommen, welche dann, wie grundsätzlich bekannt, mittels eines Trennungsalgorithmus, beispielsweise eines Schicht-GRAPPA-Algorithmus, wieder getrennt werden können, um wie im ersten Ausführungsbeispiel der Fig. 1 Magnetresonanzbilder für die unterschiedlichen Kontraste/ Wartezeiten 3, 5 zu ermitteln und die wenigstens eine Parameterkarte daraus zu errechnen.

Konkret sei beispielsweise zur Ermittlung der T1-Relaxationszeit aus Messungen zu verschiedenen Inversionszeiten auf die eingangs bereits genannte DE 10 2012 206 585 A1 verwiesen.

Durch die gleichzeitige Präparation (und gemäß Fig. 2 gleichzeitige Vermessung) mehrerer Schichten lässt sich eine deutliche Reduzierung der Gesamtaufnahmezeit für die Magnetresonanzdaten zur Ermittlung der wenigstens einen Parameterkarte erreichen.

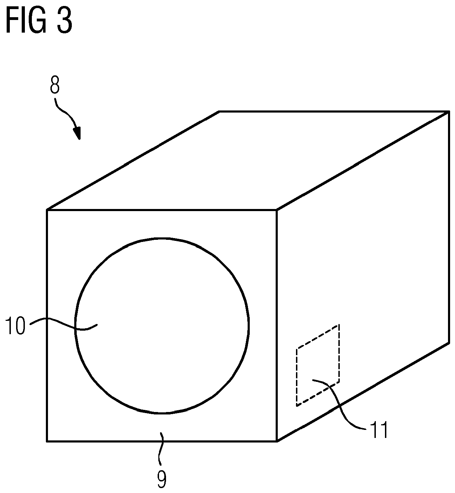

Fig. 3 zeigt schließlich eine Prinzipskizze einer erfindungsgemäßen Magnetresonanzeinrichtung 8. Diese weist eine Hauptmagneteinheit 9 auf, die eine Patientenaufnahme 10 definiert, in die ein Patient mittels einer Patientenliege (hier nicht dargestellt) zur Aufnahme von Magnetresonanzdaten eingefahren werden kann. Die Patientenaufnahme 10 umgebend können eine Hochfrequenzspulenanordnung und eine Gradientenspulenanordnung vorgesehen sein.

Der Betrieb der Magnetresonanzeinrichtung 8 wird von einer Steuereinrichtung 11 gesteuert, die auch zur Durchführung des erfindungsgemäßen Verfahrens ausgebildet ist. Hierzu kann die Steuereinrichtung 11 neben einer Sequenzeinheit zur Steuerung der Aufnahme von Magnetresonanzdaten auch eine Gesamtpulsermittlungseinheit bzw. allgemein Planungseinheit aufweisen, um geeignete Gesamtpulse 2, 2′, 2ʺ 2‴ zu ermitteln und den Zeitablauf der Aufnahme von Magnetresonanzdaten gemäß beispielsweise den Figuren 1 oder 2 zu planen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Aufnahme von Magnetresonanzdaten zur Ermittlung wenigstens einer einen Materialparameter in dem Aufnahmebereich beschreibenden Parameterkarte mit einer Magnetresonanzeinrichtung (8), wobei das Aufnahmegebiet mehrere Schichten aufweist und zur Aufnahme der Magnetresonanzdaten wenigstens teilweise ein schichtspezifischer Präparationspuls verwendet wird, wobei Magnetresonanzdaten nach unterschiedlichen Wartezeiten (3, 5) nach dem Präparationspuls vermessen werden, **dadurch gekennzeichnet, dass** zur Aufnahme von Magnetresonanzdaten unterschiedlicher Wartezeiten (3, 5) aus wenigstens zwei Schichten ein durch Überlagerung der schichtspezifischen Präparationspulse für die einzelnen Schichten ermittelter Gesamtpuls (2, 2′, 2′, 2‴) ausgeben wird und die Magnetresonanzdaten der Schichten nach den jeweiligen Wartezeiten (3, 5) mit einer Auslesesequenz ausgelesen werden, wobei schichtspezifische Präparationspulse unterschiedlicher Flipwinkel zu dem Gesamtpuls (2, 2', 2', 2‴) überlagert werden.

2. Verfahren nach Anspruch 1, **dadurch gekennzeichnet, dass** als Auslesesequenz eine Spinechosequenz, insbesondere eine Turbo-Spinechosequenz, und/oder als schichtspezifischer Präparationspuls wenigstens ein Inversionspuls und/oder ein Sättigungspuls verwendet werden.

3. Verfahren nach einem der vorangehenden Ansprüche, **dadurch gekennzeichnet, dass** wenigstens drei Schichten vermessen werden, wobei für wenigstens zwei Schichten, auf die der Gesamtpuls (2, 2', 2', 2‴) wirkt, die Magnetresonanzdaten einer gemeinsamen Wartezeit (3, 5) gleichzeitig ausgelesen und mittels eines Trennungsalgorithmus getrennt werden.

4. Magnetresonanzeinrichtung (8), aufweisend eine zur Durchführung eines Verfahrens nach einem der vorangehenden Ansprüche ausgebildete Steuereinrichtung (11).

5. Computerprogramm, welches die Schritte eines Verfahrens nach einem der Ansprüche 1 bis 3 durchführt, wenn es auf einer Steuereinrichtung (11) einer Magnetresonanzeinrichtung (8) ausgeführt wird.

6. Elektronisch lesbarer Datenträger, auf dem ein Computerprogramm nach Anspruch 5 gespeichert ist.

## Claims

1. Method for recording magnetic resonance data for determining at least one parameter map describing a material parameter in the scanning region with a magnetic resonance apparatus (8), wherein the scanning area has a plurality of slices and, for recording the magnetic resonance data, a slice-specific preparation pulse is used at least partially, wherein magnetic resonance data is scanned after different waiting times (3, 5) following the preparation pulse, **characterised in that** for recording magnetic resonance data of different waiting times (3, 5) from at least two slices, an overall pulse (2, 2′, 2′, 2‴) determined by overlaying the slice-specific preparation pulses for the individual slices is output and the magnetic resonance data of the slices is read out with a readout sequence after the respective waiting times (3, 5), wherein slice-specific preparation pulses of different flip angles are overlaid to form the overall pulse (2, 2', 2', 2‴).

2. Method according to claim 1, **characterised in that** as the readout sequence a spin echo sequence, in particular a turbo spin echo sequence, and/or as a slice-specific preparation pulse, at least one inversion pulse and/or a saturation pulse are used.

3. Method according to one of the preceding claims, **characterised in that** at least three slices are scanned, wherein for at least two slices on which the overall pulse (2, 2′, 2′, 2‴) acts, the magnetic resonance data of a common waiting time (3, 5) is read out simultaneously and is separated by means of a separation algorithm.

4. Magnetic resonance apparatus (8), having a control device (11) configured for carrying out a method according to one of the preceding claims.

5. Computer program which carries out the steps of a method according to one of claims 1 to 3 when it is executed on a control device (11) of a magnetic resonance apparatus (8).

6. Electronically readable data carrier on which a computer program according to claim 5 is stored.

## Revendications

1. Procédé d'enregistrement de données de résonance magnétique pour la détermination au moins d'une carte de paramètre, décrivant un paramètre de matériau dans la partie d'enregistrement, par un dispositif (8) de résonance magnétique, la région d'enregistrement ayant plusieurs tranches et une impulsion de préparation spécifique à une tranche étant utilisée au moins en partie pour l'enregistrement des données de résonance magnétique, dans lequel on mesure des données de résonance magnétique après des temps (3, 5) d'attente différents après l'impulsion de préparation, **caractérisé en ce que**
pour l'enregistrement de données de résonance magnétique de temps (3, 5) d'attente différents d'au moins deux tranches, on émet une impulsion (2, 2′, 2′, 2‴) d'ensemble déterminée par superposition des impulsions de préparation spécifiques à une tranche pour les diverses tranches et on lit, par une séquence de lecture, les données de résonance magnétique des tranches après les temps (3, 5) d'attente respectifs, dans lequel on superpose des impulsions de préparation spécifiques à une tranche d'angle de flip différent en l'impulsion (2, 2′, 2′, 2‴) d'ensemble.

2. Procédé suivant la revendication 1, **caractérisé en ce que** l'on utilise, comme séquence de lecture, une séquence de spin écho, notamment une séquence de turbo spin écho et/ou, comme impulsion de préparation spécifique à une tranche, au moins une impulsion d'inversion et/ou une impulsion de saturation.

3. Procédé suivant l'une des revendications précédentes, **caractérisé en ce que** l'on mesure au moins trois tranches, dans lequel pour au moins deux tranches, sur lesquelles agit l'impulsion (2, 2′, 2′, 2‴) d'ensemble, on lit en même temps les données de résonance magnétique d'un temps (3, 5) d'attente commun et on les sépare au moyen d'un algorithme de séparation.

4. Dispositif (8) de résonance magnétique, comportant un dispositif (11) de commande, constitué pour effectuer un procédé suivant l'une des revendications précédentes.

5. Programme d'ordinateur, qui effectue les stades d'un procédé suivant l'une des revendications 1 à 3, lorsqu'il est réalisé sur un dispositif (11) de commande d'un dispositif (8) de résonance magnétique.

6. Support de données, déchiffrable électroniquement, sur lequel est mis en mémoire un programme d'ordinateur suivant la revendication 5.
